# EUROPÄISCHE PATENTSCHRIFT

(11) **EP 0 984 535 B1**
(45) Veröffentlichungstag und Bekanntmachung des Hinweises auf die Patenterteilung: **17.08.2005**
(21) Anmeldenummer: 99114805.7
(22) Anmeldetag: 28.07.1999
(51) Int. Cl.: H01S 5/12

(54) **Halbleiterlaser mit Gitterstruktur**
Semiconductor laser with grating structure
Laser semi-conducteur comportant un réseau

(30) Priorität: 31.08.1998 DE 29815522 U; 21.04.1999 US 296059
(43) Veröffentlichungstag der Anmeldung: 08.03.2000
(73) Patentinhaber: Forchel, Alfred, Prof. Dr., 97074 Würzburg (DE); Kamp, Martin, 97082 Würzburg (DE)
(72) Erfinder: Forchel, Alfred, Prof. Dr., 97074 Würzburg (DE); Kamp, Martin, 97082 Würzburg (DE)

(56) Entgegenhaltungen:
- KAMP M ET AL: "High performance laterally gain coupled InGaAs/AlGaAs DFB lasers" CONFERENCE PROCEEDINGS. 1998 INTERNATIONAL CONFERENCE ON INDIUM PHOSPHIDE AND RELATED MATERIALS (CAT. NO.98CH36129), CONFERENCE PROCEEDINGS. 1998 INTERNATIONAL CONFERENCE ON INDIUM PHOSPHIDE AND RELATED MATERIALS, TSUKUBA, JAPAN, 11-15 MAY 1998, Seiten 831-834, XP000998200 1998, New York, NY, USA, IEEE, USA ISBN: 0-7803-4220-8
- MARTIN R D ET AL: "CW PERFORMANCE OF AN INGAAS-GAAS-ALGAAS LATERALLY-COUPLED DISTRIBUTED FEEDBACK (LC-DFB) RIDGE LASER DIODE" IEEE PHOTONICS TECHNOLOGY LETTERS,US,IEEE INC. NEW YORK, Bd. 7, Nr. 3, 1. März 1995 (1995-03-01), Seiten 244-246, XP000510265 ISSN: 1041-1135
- KAMP M ET AL: "LOW-THRESHOLD HIGH-QUANTUM-EFFICIENCY LATERALLY GAIN-COUPLED INGAAS/AIGAAS DISTRIBUTED FEEDBACK LASERS" APPLIED PHYSICS LETTERS,US,AMERICAN INSTITUTE OF PHYSICS. NEW YORK, Bd. 74, Nr. 4, 25. Januar 1999 (1999-01-25), Seiten 483-485, XP000805752 ISSN: 0003-6951
- LEGGE M ET AL: "Low threshold II-VI laser diodes with transversal and longitudinal single-mode emission" JOURNAL OF CRYSTAL GROWTH,NORTH-HOLLAND PUBLISHING CO. AMSTERDAM,NL, Bd. 214-215, Juni 2000 (2000-06), Seiten 1045-1048, XP004201167 ISSN: 0022-0248
- CHEN N ET AL: "1.3- mu m wavelength InP laterally coupled distributed feedback ridge laser" CONFERENCE ON OPTICAL FIBER COMMUNICATIONS. TECHNICAL DIGEST. POSTCONFERENCE EDITION. 1997 OSA TECHNICAL DIGEST SERIES. VOL.6 (IEEE CAT. NO.97CH36049), PROCEEDINGS OF OPTICAL FIBER COMMUNICATION CONFERENCE (ISBN 1 55752 481 5), DALLAS, TX, USA, 16-21, Seiten 237-238, XP002164961 1997, Washington, DC, USA, Opt. Soc. America, USA ISBN: 1-55752-480-7

## Beschreibung

Die vorliegende Erfindung betrifft einen Halbleiterlaser mit einem Halbleitersubstrat, einer auf dem Halbleitersubstrat angeordneten Laserschicht, einem mit Abstand zur Laserschicht angeordneten Wellenleitersteg und einer parallel zur Laserschicht angeordneten, streifenförmig ausgebildeten Gitterstruktur. Des weiteren betrifft die vorliegende Erfindung ein Verfahren zur Herstellung eines derartigen Halbleiterlasers.

Bekannte Halbleiterlaser der eingangs genannten Art, die fachsprachlich auch als sogennante DFB (Distributed Feedback - ) Laserdioden bezeichnet werden, weisen eine sich durch die Laserschicht hindurch erstreckende Gitterstruktur auf, die die Ausbildung einer monomodigen Laserdiode ermöglicht, bei der im Unterschied zu mehrmodigen Laserdioden Laserstrahlung mit einer bestimmten Lasermode emittiert wird und weitere Moden durch die Gitterstruktur unterdrückt werden. Die Herstellung der in der bekannten Weise aufgebauten DFB-Laserdioden erweist sich insbesondere wegen des angewandten Herstellungs- und Testverfahrens und der damit verbundenen hohen Ausschussquote als extrem kostenaufwendig. Bei der Herstellung der bekannten DFB-Laserdioden wird auf Waferebene, basierend auf einem Halbleitersubstrat, die Struktur des Halbleiterwafers durch Epitaxie auf dem Halbleitersubstrat hergestellt. Zur Ausbildung der Gitterstruktur in der Laserschicht wird nach Erreichen etwa der halben Schichthöhe der Epitaxiestruktur das Epitaxiewachstum unterbrochen und in einem Lithgraphie- und Abtragverfahren die Gitterstruktur eingebracht. Danach wird das Epitaxiewachstum fortgesetzt. Aufgrund der Epitaxieunterbrechung in der Ausbildung der Laserschicht und dem nachfolgenden Überwachsen der in die Halbschicht eingebrachten Gitterstruktur werden Defekte in die Laserschicht induziert, die sich nachteilig auf die Eigenschaften der Laserschichten auswirken und sich etwa in einem höheren Stromverbrauch oder in einer reduzierten Lebensdauer der Laserdioden äussern.

Aufgrund der wechselseitigen Beeinflussungen zwischen der Laserschicht und der in der Laserschicht ausgebildeten Gitterstruktur hinsichtlich der Verstärkungseigenschaften des Halbleiterlaserwafers sind die Eigenschaften eines auf die vorstehende Art und Weise hergestellen Halbleiterlaserwafers nicht exakt vorgebbar. Da die Eigenschaften des Halbleiterlaserwafers erst nach Abschluss des Epitaxiewachstums und vollständiger Ausbildung der Laserschicht im Versuchsbetrieb ermittelt werden können, kann auch das Verstärkungsspektrum des Halbleiterlaserwafers erst nach Ausbildung der Gitterstruktur in der Laserschicht ermittelt werden, so dass keine genaue Anpassung der Gitterstruktur an das Verstärkungsspektrum der Laserschichten möglich ist und demzufolge die bekannten DFB-Laserdioden auch nicht exakt entsprechend definierter Vorgaben bezüglich der gewünschten Lasermode bzw. der gewünschten Wellenlänge herstellbar sind. Vielmehr bedingt die vorstehend wiedergegebene Struktur der bekannten DFB-Laserdioden ein Herstellungsverfahren, bei dem unterschiedliche Gitterstrukturen in der Laserschicht eines Halbleiterlaserwafers ausgebildet werden müssen, um im nachhinein durch Überprüfung des aus dem Halbleiterlaserwafer vereinzelten Laserdioden genau diejenigen Laserdioden zu ermitteln, die die gewünschte Lasermode mit der gewünschten Wellenlänge emittieren. Hierdurch wird deutlich, dass der strukturelle Aufbau der bekannten DFB-Laserdioden die Herstellung einer Vielzahl von Laserdioden notwendig macht, um aus dieser Vielzahl die für den beabsichtigten Anwendungszweck geeigneten Laserdioden auszuwählen, also diejenigen Laserdioden, die eine Laserstrahlung mit der gewünschten Wellenlänge emittierten.

### Im Dokument:

M. Kamp, J. Hofmann, A. Forchel, F. Schäfer, and J.P. Reithmaier, "High performance laterally gain coupled InGaAs/AlGaAs DFB lasers", Conference proceedings, International conference on indium phophide and related materials, Seiten: 831-834, 1998, wird eine Struktur beschrieben, die eine vereinfachte Herstellung von Laserdioden mit definierter Wellenlänge ermöglicht. Die veröffentlichte Struktur verwendet ein seitlich am Laserwellenleiter definiertes Gitter aus Metall.

Aufgabe der vorliegenden Erfindung ist es nun, eine weitere Verbesserung der im oben zitierten Dokument beschriebenen Laserdiode vorzuschlagen. Weiterhin ist es Aufgabe der vorliegenden Erfindung, ein für die Herstellung einer erfindungsgemässen DFB - Laserdiode besonders geeignetes Verfahren vorzuschlagen.

Diese Aufgaben werden durch einen Halbleiterlaser mit den Merkmalen des Anspruchs 1 bzw. durch ein Verfahren zur Herstellung eines Halbleiterlasers mit den Merkmalen des Anspruchs 5 gelöst.

Die erfindungsgemässe Lösung nach Anspruch 1 ermöglicht eine DFB-Laserdiode mit einer nach Abschluss des Epitaxiewachstums der Laserschicht zur Fertigstellung eines Halbleiterlaserwafers und nachfolgend der Ausbildung des Wellenleiterstegs erzeugten Gitterstruktur. Aufgrund dieser strukturbedingten nachträglichen Erzeugung der Gitterstruktur ist es möglich, vor Erzeugen der Gitterstruktur das individuelle Verstärkungsspektrum der Laserschicht bzw. des Halbleiterlaserwafers zu ermitteln, um dann nachträglich durch gezielte Vorgaben der Parameter der Gitterstruktur exakt das gewünschte Laserprofil herzustellen und so reproduzierbar DFB-Laserdioden mit exakt definierter Wellenlänge bzw. Lasermode herstellen zu können.

Darüber hinaus ermöglicht der erfindungsgemässe Strukturaufbau eine ungestörte, kontinuierliche Ausbildung der Laserschicht in der Epitaxie, so dass unnötige Defekte, die die Leistungscharakteristik der Laserschicht bzw. der DFB-Laserdiode beeinträchtigen können, erst gar nicht auftreten. Durch die Anordnung der Gitterstruktur mit Abstand zur aktiven Laserschicht wird auch eine nachträgliche Beeinträchtigung der Laserschicht ausgeschlossen. Die Gitterstruktur moduliert periodisch die Verluste und die Brechungsstärke des sich durch den Laser hindurch ausbreitenden Lichts. Hierdurch ermöglicht die erfindungsgemässe DFB - Laserdiode eine komplexe Kopplung der Laserstrahlung mit der Gitterstruktur mit einer lateralen Modulation des Real- und Imaginärteils des Brechungsindex. Erfindungsgemässe Laserdioden weisen daher eine hohe Rückstrahlungsunempfindlichkeit auf, die einen Einsatz ohne optischen Isolator, beispielsweise in Anwendungen zur Glasfaserübertragung, möglich macht.

Um den Abstand bzw. die Relativlage der Gitterstruktur bezüglich der aktiven Laserschicht der DFB-Laserdiode bei der Herstellung der DFB-Laserdiode möglichst exakt einstellen zu können, ist die Gitterstruktur auf einer parallel zur Laserschicht angeordneten Isolationsschicht angeordnet.

Zur Verbessung der elektrischen Injektion ist die metallische Gitterstruktur auf eine dünne Isolierschicht (beispielsweise aus natürlichem oder künstlich hergestelltem Oxid) aufgebracht sein. Die Isolierschicht sollte so gewählt werden, dass der Brechungsindex in der Nähe des Brechungsindex des Halbleiters liegt und die Isolierung eine geringe Dicke aufweist (typischerweise einige Nanometer). Diese Schicht dient auch zur Verhinderung einer möglichen Durchdringung der Laserschichten mit dem Gittermaterial und somit ebenfalls als Barrierenschicht.

Wenn zur Ausbildung der Gitterstruktur ein Metall, beispielsweise Chrom, verwendet wird, werden die vorstehend beschriebenen vorteilhaften Effekte umfassend realisiert. Unabhängig von dem zur Ausbildung der Gitterstruktur gewählen Material kann die Gitterstruktur auch durch einen Materialabtrag, also nicht durch einen Materialauftrag, erzeugt werden.

Als besonders vorteilhaft erweist es sich, wenn die Strukturbereiche der Gitterstruktur angrenzend an seitliche Flanken des Wellenleiterstegs angeordnet sind. Hierdurch wird eine möglichst geringe Beeinflussung der Verstärkungsleistung des Lasers durch die Gitterstruktur und insbesondere eine wirksame Kopplung zwischen der Laserstrahlung und der Gitterstruktur sichergestellt.

Bezüglich einer Optimierung der elektrischen Injektionsfläche und der Auswirkungen der Gitterstruktur erweist es sich auch als vorteilhaft, wenn die Flanken des Wellenleiterstegs im Rahmen der durch das Bearbeitungsverfahren erreichbaren Genauigkeit weitestgehend rechtwinkelig zur Erstreckungsebene der Gitterstruktur angeordnet sind.

Das erfindungsgemässe Verfahren weist die Merkmale des Anspruchs 5 auf.

Gemäss dem erfindungsgemässen Verfahren erfolgt, basierend auf einem Halbleitersubstrat, die Herstellung einer vollständigen Halbleiterlaserstruktur in einem Epitaxieverfahren mit anschliessender Herstellung eines Wellenleiterstegs durch Beaufschlagung der Halbleiterlaserstruktur mit einem Materialabtragsverfahren zur Ausbildung von beidseits des Wellenleiterstegs angeordneten Trägerflächen sowie anschliessender Aufbringung einer Gitterstruktur auf die Trägerflächen.

Unabhängig von dem zur Ausbildung der Gitterstruktur gewählten Material kann die Gitterstruktur auch durch einen Materialabtrag, also nicht nur durch einen Materialauftrag, erzeugt werden.

Das erfindungsgemässe Verfahren ermöglicht somit ein einer ersten Verfahrensphase die Herstellung funktionsfähiger Laserdioden, wodurch eine genaue Überprüfung und Feststellung der elektrischen und optischen Eigenschaften, also beispielsweise einer Feststellung des individuellen Verstärkungsspektrums des für die Herstellung des Lasers verwendeten Halbleiterwafers, möglich ist. Erst anschliessend werden in einer zweiten Verfahrensphase die orginär mehrmodigen Laserdioden durch Erzeugung von in ihren Parametern definierten Gitterstrukturen entlang des Wellenleiterstegs zu monomodigen DFB -Laserdioden mit jeweils in Abhängigkeit von den Parametern der Gitterstrukturen definierten Eigenschaften umgewandelt.

Vor Aufbringung der Gitterstruktur wird auf den Trägerflächen eine Isolationsschicht ausgebildet.

Im Falle der Erzeugung der Gitterstruktur durch Aufbringung einer Gitterstruktur auf die Trägerflächen erweist sich die Anwendung eines lithographischen Verfahrens, insbesondere die Anwendung eines Elektronenstrahllithographieverfahrens, mit nachfolgender Metallisierung der lithographischen Struktur als besonders vorteilhaft.

Nachfolgend wird der Aufbau einer Ausführungsform einer erfindungsgemässen DFB - Laserdiode und ein mögliches Verfahren zu deren Herstellung anhand der Zeichnungen näher erläutert. Es zeigen:
- **Fig. 1a bis 1c**: verschiedene Stadien bei der Herstellung einer DFB- Laserdiode mit lateraler Gitterstruktur;
- **Fig. 2**: eine Rasterelektronenaufnahme unter Darstellung einer Draufsicht auf die beidseitig eines Wellenleiters angeordnete Gitterstruktur;
- **Fig. 3**: eine Diagrammdarstellung eines möglichen Verstärkungsspektrums der in **Fig. 1c** dargestellten Laserdiode;
- **Fig. 4**: eine graphische Darstellung der Abhängigkeit zwischen dem Verstärkungsspektrum bzw. der Wellenlänge der von der Laserdiode emittierten Strahlung und der Gitterkonstanten der Gitterstruktur;

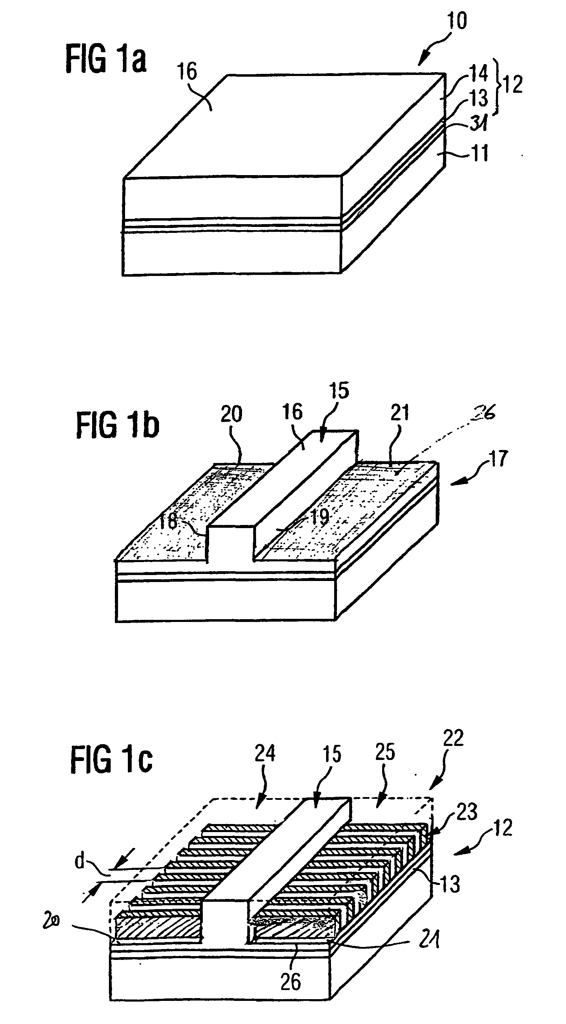

**Fig. 1a** zeigt einen Halbleiterlaser oder eine Basislaserdiode 10 mit einem Halbleitersubstrat 11 und einer darauf aufgewachsenen Epitaxieschicht 12 in vereinfachter Darstellung und in perspektivischer Ansicht. Teil der Epitaxiestruktur 12 ist eine Laserschicht 13, die auf einer Puffer- und Kontaktschicht 31 angeordnet ist und nach oben durch eine Deckschicht 14 abgedeckt wird

Die in **Fig. 1a** dargestellte Basislaserdiode 10 weist eine quaderförmige Gestalt mit ebener Diodenoberfläche 16 auf. Ausgehend von der in **Fig. 1a** dargestellten Basislaserdiode 10 wird die in **Fig. 1c** dargestellte Ausführungsform einer erfindungsgemässen DFB - Laserdiode 22 in zwei wesentlichen Verfahrensphase herstellt, wobei **Fig. 1b** als eine Übergangsform nach Durchführung einer ersten Verfahrensphase eine Wellenleiterdiode 17 darstellt ist, bei der die Diodenfläche 16 mit einem Materialabtragsverfahren, wie beispielswiese einem Trockenätzverfahren beaufschlagt worden ist, um die dargestellte stufenförmige Oberflächenausbildung mit einem in Längsrichtung der Wellenleiterdiode 17 verlaufenden Wellenleitersteg 15 auszubilden. Durch das vorgenannte Materialabtragsverfahren entstehen beidseitig von Flanken 18, 19 des Wellenleiters 15 ausgebildete Oberflächen, die nachfolgend als Trägerflächen 20 und 21 bezeichnet werden, wobei die Trägerflächen von einer dünnen Isolationsschicht 26 bedeckt sind.

Ausgehend von der in **Fig. 1b** dargestellten Wellenleiterdiode 17 wird die in **Fig. 1c** dargestellten Ausführungsform einer DFB - Laserdiode 22 durch Erzeugung einer Metallgitterstruktur 23 mit zwei Strukturbereichen 24 und 25, die jeweils in den Trägerflächen 20 bzw. 21 angeordnet sind, durch Beaufschlagung der Trägerflächen 20 und 21 mit einem Elektronenstrahllithographieverfahren und einem nachfolgenden, hier nicht näher beschriebenem Metallisierungsvorgang hergestellt. Ergebnis dieser zweiten Verfahrensphase ist die in **Fig. 1c** dargestellte DFB- Laserdiode 22 mit der in den Trägerflächen 20 und 21 oberhalb der Laserschicht 13 angeordneten Metallgitterstruktur 23. Um die Relativlage der beidseitig zum Wellenleitersteg 15 in der Epitaxiestruktur 12 angeordneten Strukturbereiche 24 und 25 der Metallgitterstruktur 23 zur Laserschicht 13 genau definieren zu können, ist in der Epitaxiestruktur oberhalb der Laserschicht 13 die beispielsweise als Ätzstopschicht aus gebildete Isolierschicht 26 vorgesehen, die die Tiefe einer unter Anwendung eines Ätzverfahrens hergestellten Lithographiestruktur in der Epitaxiestruktur 12 begrenzt und hierdurch die Relativlage der Metallgitterstruktur 23 gegenüber der Laserschicht 13 definiert.

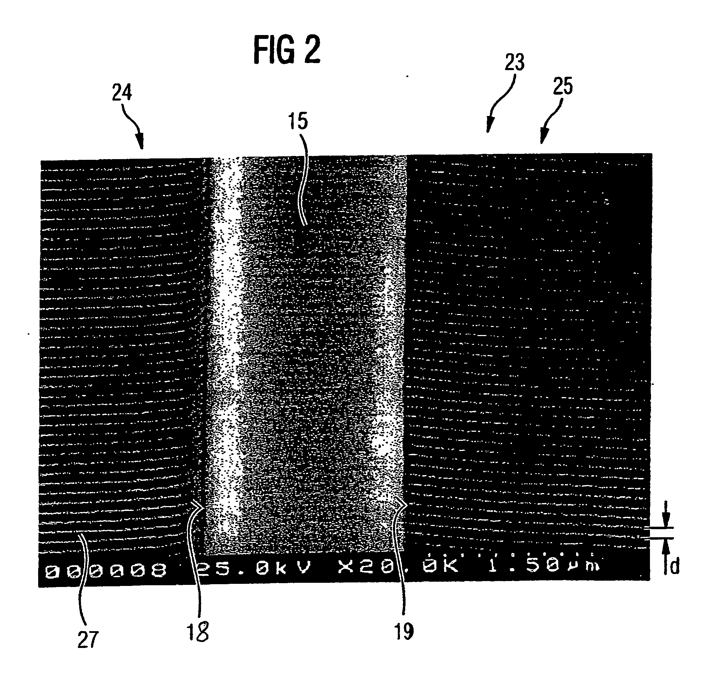

Wie die in **Fig. 2** wiedergegebene Elektronenmikroskopieaufnahme einer Draufsicht auf die in **Fig. 1c** schematisch dargestellte Metallgitterstrukur 23 zeigt, erstrecken sich die aus hier äquidistant zueinander angeordneten Gitterstegen 27 aufgebauten Strukturbereiche 24 und 25 bis an die Flanken 18 und 19 des Wellenleiters 15 heran. Die Charakteristik der Metallgitterstruktur 23 wird zum einen durch den Abstand zwischen den Gitterstegen 27 oder die Gitterkonstante d, die Geometrie der Gitterstegen 27 und das für die Metallgitterstruktur 23 verwendete Metall bestimmt.

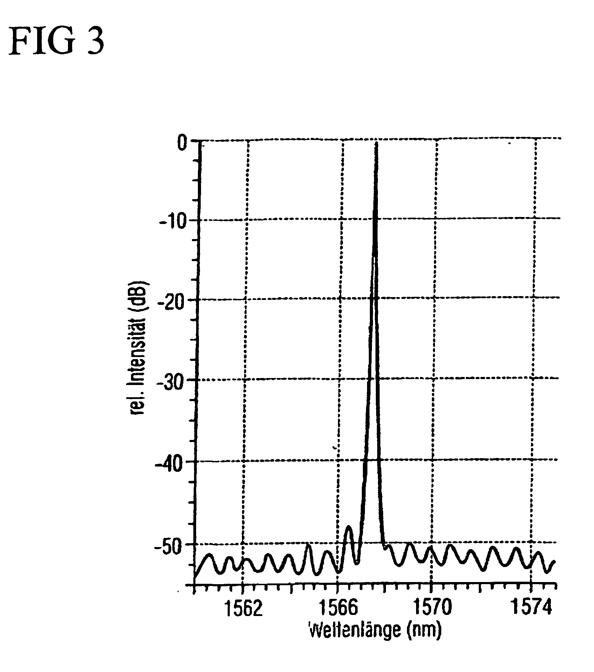

**Fig. 3** macht die durch die Metallgitterstruktur 23 erzielte Filterwirkung deutlich, da, wie aus **Fig. 3** ersichtlich, Nebenmoden der aus der emittierten Laserstrahlung wirksam unterdrückt werden und im wesentlichen nur die Emission einer Lasermode mit exakt definierter Wellenlänge zugelassen wird.

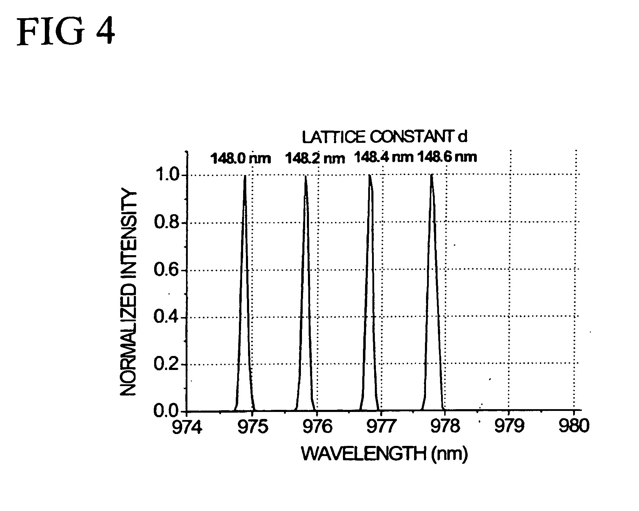

**Fig. 4** zeigt die Auswirkungen von Änderungen der Gitterkonstante d **(Fig. 1c)** auf die Wellenlänge. **Fig. 4** macht deutlich, dass durch Änderung der Gitterkonstanten d eine hochgenaue Feinabstimmung der Wellenlänge möglich ist, so dass ausgehend von einem vorgegebenen individuellen Verstärkungsspektrum einer in **Fig. 1a** beispielhaft dargestellten Basislaserdiode 10 durch gezielte Auswahl der Parameter der Gitterstruktur, also beispielsweise der Gitterkonstante, eine hochgenaue Einstellung der Wellenlänge für den beabsichtigten Einsatzfall der betreffenden Laserdiode einstellbar ist. Beispielsweise kann auch durch die Wahl des Metalls für die Metallgitterstruktur 23 die komplexe Kopplung zwischen der Laserstrahlung und der Gitterstruktur, also etwa die absolute Grösse und das relative Verhältniss des Real- und Imaginärteils des Brechnungsindex- und damit der Anteil von Brechungsindexkopplung und Absorptionskopplung in weiten Grenzen eingestellt werden. Auch stellt das sogenannte "Tastverhältnis" der Gitterstruktur, also das Verhältnis der Gitterstegbreite zur Gitterkonstante, eine Optimierungsgrösse dar.

## Patentansprüche

1. Halbleiterlaser mit einem Halbleitersubstrat, einer auf dem Halbleitersubstrat angeordneten Laserschicht, einem mit Abstand zur Laserschicht angeordneten Wellenleitersteg und einer parallel zur Laserschicht angeordneten, streifenförmig ausgebildeten Gitterstruktur,
**dadurch *gekennzeichnet*,**
**dass** die Gitterstruktur (23) zwei Strukturbereiche (24, 25) aufweist, die beidseitig des Wellenleiterstegs (15) angeordnet und mit Abstand zur Laserschicht (13) auf einer Isolationsschicht (26) oberhalb der Laserschicht (13) ausgebildet sind.

2. Halbleiterlaser nach Anspruch 1
**dadurch *gekennzeichnet*,**
**dass** die Gitterstruktur (23) aus Metall hergestellt ist.

3. Halbleiterlaser nach Anspruch 1 oder 2
**dadurch *gekennzeichnet*,**
**dass** die Gitterstruktur (23) aus Chrom oder einer Chromlegierung hergestellt ist.

4. Halbleiterlaser nach einem oder mehreren der vorangehenden Ansprüche,
**dadurch *gekennzeichnet*,**
**dass** die Flanken (18, 19) des Wellenleiterstegs (15) im wesentlichen rechtwinklig zur Erstreckungsebene der Gitterstruktur (23) angeordnet sind.

5. Verfahren zur Herstellung eines Halbleiterlasers basierend auf einem Halbleitersubstrat mit einer auf dem Halbleitersubstrat angeordneten Laserschicht und einer streifenförmig ausgebildeten Gitterstruktur
***gekennzeichnet* durch** die Verfahrensschritte:
- Herstellung einer vollständigen Halbleiterlaserstruktur in einem Epitaxieverfahren
- Herstellung eines Wellenleiterstegs (15) **durch** Beaufschlagung der Halbleiterlaserstruktur mit einem Materialabtragsverfahren zur Ausbildung von beidseitig des Wellenleiterstegs (15) angeordneten Trägerflächen (20, 21)
- Ausbildung einer Isolationsschicht (26) auf den Trägerflächen (20, 21)
- Aufbringung der Gitterstruktur (23) auf die Isolationsschicht

6. Verfahren nach Anspruch 5,
**dadurch *gekennzeichnet*,**
**dass** zur Aufbringung einer Gitterstruktur (23) aus Metall, ein Lithographieverfahren mit nachfolgender Metallisierung der lithographischen Struktur eingesetzt wird.

## Claims

1. A semiconductor laser having a semiconductor substrate, a laser layer arranged on the semiconductor substrate, a waveguide ridge arranged at a distance from the laser layer, and a strip-shaped lattice structure conformed parallel to the laser layer,
***characterised in that***
the lattice structure (23) has two structural areas (24, 25), which are arranged on either side of the waveguide ridge (15) and are conformed at a distance from the laser layer (13) on an insulation layer (26) on top of the laser layer (13).

2. The semiconductor laser in accordance with claim 1
***characterised in that***
the lattice structure (23) is made out of metal.

3. The semiconductor laser in accordance with claim 1 or 2
***characterised in that***
the lattice structure (23) is made from chromium or a chromium alloy.

4. The semiconductor laser in accordance with one or more of the preceding claims,
***characterised in that***
the flanks (18, 19) of the waveguide ridge (15) are arranged essentially perpendicular to the extension plane of the lattice structure (23).

5. A method for producing a semiconductor laser based on a semiconductor substrate with a laser layer arranged on the semiconductor substrate and a strip-shaped lattice structure
***characterised by*** the procedural steps of:
- producing a complete semiconductor laser structure in an epitaxy process
- producing a waveguide ridge (15) by subjecting the semiconductor laser structure to a material removal method for developing the carrier surfaces (20, 21) arranged on either side of the waveguide ridge
- forming an insulation layer (26) on the carrier surfaces (20, 21)
- applying the lattice structure (23) to the insulation layer.

6. The method in accordance with claim 5,
***characterised in that***
a lithography method with subsequent metallization of the lithographic structure is used to apply a lattice structure (23) made from metal.

## Revendications

1. Laser à semi-conducteur comportant un substrat de semi-conducteur, une couche laser disposée sur un substrat de semi-conducteur, un guide d'ondes à nervure disposé à distance de la couche laser et une structure réticulaire en forme de bande disposée parallèlement à la couche laser,
***caractérisé* en ce que**
la structure réticulaire (23) présente deux zones structurelles (24, 25) qui sont disposées des deux côtés du guide d'ondes à nervure (15) et sont réalisées à distance de la couche laser (13) sur une couche d'isolation (26) au dessus de la couche laser (13).

2. Laser à semi-conducteur selon la revendication 1,
***caractérisé* en ce que**
la structure réticulaire (23) est fabriquée en métal.

3. Laser à semi-conducteur selon la revendication 1 ou 2,
***caractérisé* en ce que**
la structure réticulaire (23) est fabriquée en chrome ou en alliage de chrome.

4. Laser à semi-conducteur selon une ou plusieurs des revendications précédentes,
***caractérisé* en ce que**
les flancs (18, 19) du conducteur guide d'onde (15) sont disposés sensiblement orthogonalement par rapport au plan d'extension de la structure réticulaire (23).

5. Procédé de fabrication d'un laser à semi-conducteur sur la base d'un substrat de semi-conducteur, avec une couche laser disposée sur le substrat de semi-conducteur et une structure réticulaire réalisée en forme de bande,
***caractérisé* par** les étapes opératoires suivantes:
- fabrication d'une structure de semi-conducteur complète par procédé d'épitaxie,
- fabrication d'un guide d'ondes à nervure (15) en sollicitant la structure de semi-conducteur par procédé d'enlèvement de matière afin de constituer des surfaces porteuses (20, 21) disposées des deux côtés du guide d'ondes à nervure (15)
- constitution d'une couche d'isolation (26) sur les surfaces porteuses (20, 21)
- application de la structure réticulaire (23) sur la couche d'isolation

6. Procédé selon la revendication 5,
***caractérisé* en ce que**
pour appliquer une structure réticulaire (23) en métal, on utilise un procédé de lithographie suivi d'une métallisation de la structure lithographique.
